# EUROPEAN PATENT APPLICATION

(11) **EP 1 041 654 A1**
(43) Date of publication of application: **04.10.2000**
(21) Application number: 00302731.5
(22) Date of filing: 31.03.2000
(51) Int. Cl.: H01L 51/20

(54) **Organic electroluminescent device**

(30) Priority: 02.04.1999 JP 9621299
(71) Applicant: TDK Corporation, Chuo-ku, Tokyo (JP)
(72) Inventor: Kobori, Isamu, c/o TDK Corporation, Tokyo 103-8272 (JP); Mitsuhashi, Etsuo, c/o TDK Corporation, Tokyo 103-8272 (JP); Arai, Michio, c/o TDK Corporation, Tokyo 103-8272 (JP)
(74) Representative: Wise, Stephen James

(57) **Abstract**

An organic EL device has a hole injecting electrode, a negative electrode, at least one organic layer having a light emitting function between the electrodes, and a high-resistance inorganic hole injecting layer between the hole injecting electrode and the organic layer. The inorganic hole injecting layer contains silicon oxide and/or germanium oxide as a main component, represented by (Si₁₋ₓGeₓ)O_{y} wherein 0 ≤ x ≤ 1 and 1.7 ≤ y ≤ 2.2, and a conductive oxide having a resistivity of up to 1x10¹⁰ Ω-cm. The device has advantages including an improved hole injection efficiency, improved emission efficiency, low operating voltage, and low cost.

## Description

This invention relates to an organic electroluminescent (EL) device and more particularly, to an inorganic/organic junction structure suitable for use in a device of the type wherein an electric field is applied to a thin film of an organic compound to emit light.

### BACKGROUND OF THE INVENTION

In general, organic EL devices have a basic configuration including a glass substrate, a transparent electrode of tin-doped indium oxide (ITO) etc., a hole transporting layer of an organic amine compound, a light emitting layer of an organic fluorescent material exhibiting electronic conductivity and intense light emission such as an aluminum quinolinol complex (Alq3), and an electrode of a metal having a low work function such as MgAg, wherein the layers are stacked on the substrate in the described order.

The device configurations which have been reported thus far have one or more organic compound layers interposed between a hole injecting electrode and an electron injecting electrode. Structures having two or three organic compound layers are typical.

Included in the two-layer structure are a structure having a hole transporting layer and a light emitting layer formed between the hole injecting electrode and the electron injecting electrode and another structure having a light emitting layer and an electron transporting layer formed between the hole injecting electrode and the electron injecting electrode. Included in the three-layer structure is a structure having a hole transporting layer, a light emitting layer, and an electron transporting layer formed between the hole injecting electrode and the electron injecting electrode. Also known is a one-layer structure wherein a single layer playing all the roles is formed from a polymer or a mixed system.

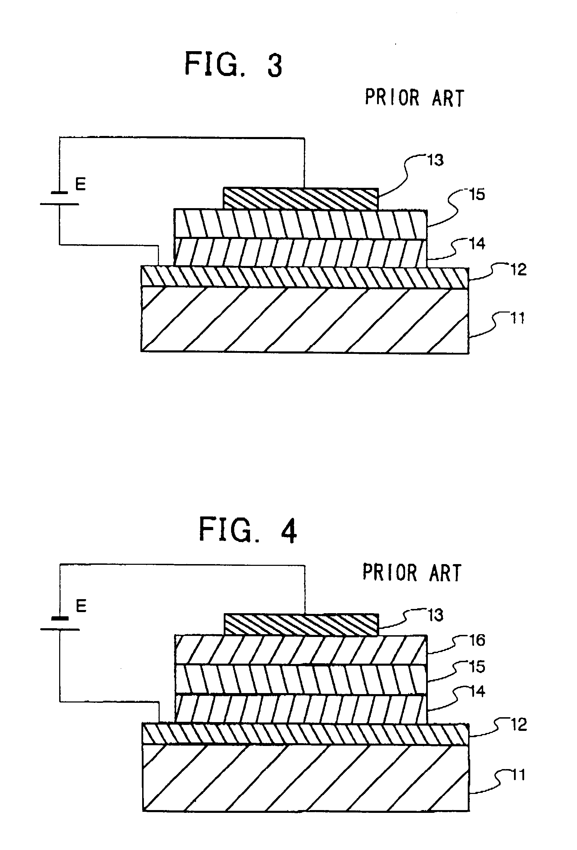

FIGS. 3 and 4 illustrate typical configurations of organic EL devices.

In FIG. 3, a hole transporting layer 14 and a light emitting layer 15, both of organic compounds, are formed between a hole injecting electrode 12 and an electron injecting electrode 13 on a substrate 11. In this configuration, the light emitting layer 15 also serves as an electron transporting layer.

In FIG. 4, a hole transporting layer 14, a light emitting layer 15, and an electron transporting layer 16, all of organic compounds, are formed between a hole injecting electrode 12 and an electron injecting electrode 13 on a substrate 11.

Many attempts have been made to improve the light emission efficiency of these organic EL devices. However, the prior art device constructions are difficult to accomplish effective recombination in the light emitting layer, partially because the hole injecting and transporting layer has a poor hole injection efficiency. It was difficult to produce a device having a fully satisfactory efficiency

### SUMMARY OF THE INVENTION

An object of the present invention is to provide an organic EL device having the advantages of an excellent hole injection efficiency, efficient hole-electron recombination in the light emitting layer, a high light emission efficiency, a low operating voltage and a low cost.

According to the invention, there is provided an organic electroluminescent (EL) device comprising a hole injecting electrode, a negative electrode, an organic layer or at least two organic layers of at least two distinct organic materials between the electrodes, at least one organic layer having a light emitting function, and a high-resistance inorganic hole injecting layer between the hole injecting electrode and the organic layer for blocking electrons and carrying holes. The high-resistance inorganic hole injecting layer contains silicon oxide and/or germanium oxide as a main component, the main component being represented by the formula: (Si₁₋ₓGeₓ)O_{y} wherein x is from 0 to 1 and y is from 1.7 to 2.2, and a conductive oxide having a resistivity of up to 1x10¹⁰ Ω-cm.

Preferably, the high-resistance inorganic hole injecting layer has a resistivity of 1 to 1x10¹¹ Ω-cm, contains 0.5 to 30 mol% of the conductive oxide, or has a thickness of 0.5 to 20 nm. Also preferably, the conductive oxide is at least one of the oxides of In, Zn, Ru, and v.

In one preferred embodiment, the organic EL device further includes a high-resistance inorganic electron injecting layer between the organic layer and the negative electrode. The high-resistance inorganic electron injecting layer contains as a first component at least one of the oxides of alkali metal elements, alkaline earth metal elements and lanthanoid elements having a work function of up to 4 eV, and as a second component at least one metal having a work function of 3 to 5 eV, the inorganic electron injecting layer being capable of blocking holes and having conduction paths for carrying electrons. Further preferably, the alkali metal element is at least one selected from the group consisting of Li, Na, K, Rb, Cs and Fr, the alkaline earth element is at least one selected from the group consisting of Mg, Ca and Sr, and the lanthanoid element is at least one selected from among La and Ce; and the second component is at least one metal selected from the group consisting of Zn, Sn, V, Ru, Sm and In. The high-resistance inorganic electron injecting layer preferably contains 0.2 to 40 mol% of the second component based on the entire components. The high-resistance inorganic electron injecting layer preferably has a thickness of 0.3 to 30 nm.

In another preferred embodiment, the organic EL device further includes an inorganic insulative electron injecting and transporting layer between the organic layer and the negative electrode. The inorganic insulative electron injecting and transporting layer contains as a main component at least one oxide selected from the group consisting of strontium oxide, magnesium oxide, calcium oxide, lithium oxide, rubidium oxide, potassium oxide, sodium oxide, and cesium oxide. Further preferably, the inorganic insulative electron injecting and transporting layer contains 80 to 99 mol% of the main component and 1 to 20 mol% of a stabilizer based on the entire components. The inorganic insulative electron injecting and transporting layer preferably has a thickness of 0.1 to 2 nm.

### BRIEF DESCRIPTION OF THE DRAWINGS

The above and other objects, features and advantages of the invention will be better understood by reading the following description taken in conjunction with the accompanying drawings.

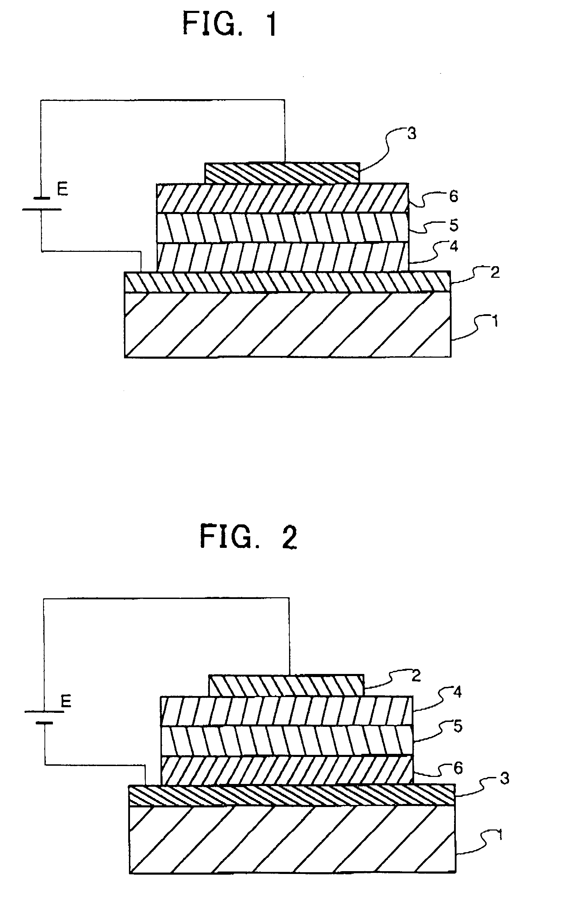

FIG. 1 is a schematic view illustrating the configuration of an organic EL device according to one embodiment of the invention.

FIG. 2 is a schematic view illustrating the configuration of an organic EL device according to another embodiment of the invention.

FIG. 3 is a schematic view illustrating a prior art organic EL device of the two-layer structure.

FIG. 4 is a schematic view illustrating a prior art organic EL device of the three-layer structure.

### BEST MODE FOR CARRYING OUT THE INVENTION

The organic EL device of the invention has a hole injecting clectrode and an electron injecting electrode on a substrate. An organic layer including at least a light emitting layer is disposed between the electrodes. A high-resistance inorganic hole injecting layer is disposed between the hole injecting electrode and the organic layer for blocking electrons and carrying holes.

The disposition of the inorganic hole injecting layer capable of carrying holes and blocking electrons between the hole injecting electrode and the organic layer ensures efficient injection of holes into the light emitting layer, leading to an improved light emission efficiency and a lower drive voltage.

Also, an oxide of a metal or metalloid such as silicon or germanium is used as the main component of the inorganic insulative hole injecting layer, and a conductive oxide having a resistivity of up to 1x10¹⁰ Ω-cm is incorporated therein to create conduction paths. This enables efficient injection of holes from the hole injecting electrode into the organic layer on the light emitting layer side. At the same time, migration of electrons from the organic layer to the hole injecting electrode is restrained, ensuring efficient recombination of holes and electrons in the light emitting layer. The organic EL device of the invention has both the advantages of inorganic material and the advantages of organic material. The organic EL device of the invention produces a luminance at least comparable to that of prior art devices having an organic hole injecting layer. Owing to high heat resistance and weather resistance, the organic EL device of the invention has a longer service life than the prior art devices and develops minimal leake and dark spots. The use of an inexpensive, readily available inorganic material in addition to relatively expensive organic materials offers the advantages of easy manufacture and a reduced manufacture cost.

The high-resistance inorganic hole injecting layer should preferably have a resistivity of 1 to 1x10¹¹ Ω-cm, and especially 1x10³ to 1x10⁸ Ω-cm in its entirety. By controlling the resistivity of the inorganic hole injecting layer within this range, the efficiency of hole injection can be drastically increased while maintaining high electron blockage. The resistivity of the inorganic hole injecting layer may be determined from a sheet resistance and a film thickness. The sheet resistance may be measured by the four-terminal method or the like.

The hole injecting layer contains an oxide of silicon and/or germanium as the main component. This oxide is represented by the formula: (Si₁₋ₓGeₓ)O_{y} wherein 0 ≤ x ≤ 1 and 1.7 ≤ y ≤ 2.2, especially 1.7 ≤ y ≤ 1.99. The main component of the high-resistance inorganic insulative hole injecting layer may be silicon oxide or germanium oxide or a mixture of silicon oxide and germanium oxide. Values of y outside the range tends to detract from the hole injecting function. The composition may be determined by x-ray spectroscopy or chemical analysis.

In addition to the main component, the high-resistance inorganic hole injecting layer contains a conductive oxide having a resistivity of up to 1x10¹⁰ Ω-cm, and preferably 10 to 1x10⁵ Ω-cm. The conductive oxide is preferably one or more of the oxides of In, Zn, Rb, and V, and especially the oxide of In or Zn. These oxides may have a stoichiometric composition such as In₂O₃, ZnO, RuO₂ or V₂O₃ or a non-stoichiometric composition deviating somewhat therefrom. When a mixture of any two or more of these oxides is used, the mixing ratio is not critical. The content of the oxide calculated as In₂O₃, ZnO, RuO₂ or V₂O₃ is preferably 0.5 Lo 30 mol%, and more preferably 1 to 20 mol% based on the entire components of the high-resistance inorganic hole injecting layer. Outside the range, a lower content may lead to a reduced hole injecting capability whereas a higher content may lead to a reduced electron blocking capability. When two or more of the conductive oxides are used, the total content should preferably fall in the above-described range.

It is believed that by incorporating the second component having a conductivity or low resistance into the first component having a high resistance and electron trapping capability, the inorganic hole injecting layer is adjusted to an optimum band gap for hole transportation, leading to improved hole injection.

In addition, the high-resistance inorganic hole injecting layer may contain less than about 5 at% in total of impurities such as H, or Ne, Ar, Kr and Xe used as the sputtering gas.

As long as the overall hole injecting layer has the above-described composition on the average, the composition of the hole injecting layer need not be uniform. A layer structure having a graded concentration in a thickness direction is acceptable.

The high-resistance inorganic hole injecting layer is normally amorphous.

The thickness of the high-resistance inorganic hole injecting layer is not critical although an appropriate thickness is about 0.5 nm to about 20 nm, more preferably about 2 nm to about 10 nm. Hole injection would become insufficient when the thickness of the hole injecting layer is outside the range.

Methods for preparing the high-resistance inorganic hole injecting layer include various physical and chemical thin film forming methods such as sputtering and evaporation, with the sputtering being preferred. Inter alia, a multi-source sputtering method of separately sputtering a target of the main component and a target of the oxide is preferable. The multi-source sputtering method permits appropriate sputtering processes to be employed for the respective targets. In the case of a single-source sputtering method, the composition may be controlled by resting a small piece of the oxide on a target of the main component and properly adjusting the ratio of their areas.

When the high-resistance inorganic hole injecting layer is formed by sputtering, the sputtering gas is preferably under a pressure of 0.1 to 1 Pa during sputtering. The sputtering gas may be any of inert gases used in conventional sputtering equipment, for example, Ar, Ne, Xe and Kr. Nitrogen (N₂) gas may be used if necessary. Reactive sputtering may be carried out in an atmosphere of the sputtering gas mixed with 1 to 99% of oxygen (O₂) gas.

The sputtering process may be an RF sputtering process using an RF power source or a DC sputtering process. The power of the sputtering equipment is preferably in the range of about 0.1 to about 10 W/cm² for RF sputtering. The deposition rate is preferably in the range of about 0.5 to about 10 nm/min., especially about 1 to about 5 nm/min. The substrate is kept at room temperature (25°C) to about 150°C during deposition.

In one preferred embodiment of the invention, the organic EL device further includes a high-resistance inorganic electron injecting layer or inorganic insulative electron injecting and transporting layer between the light emitting layer and the negative electrode.

By providing the high-resistance inorganic hole injecting and transporting layer and the high-resistance inorganic electron injecting layer or inorganic insulative electron injecting and transporting layer and disposing the light emitting layer therebetween, the organic EL device of the invention is endowed with both the advantages of inorganic material and the advantages of organic material. More particularly, the manufacture becomes easy because the physical properties at the interface between the light emitting layer and the high-resistance inorganic hole injecting and transporting layer, high-resistance inorganic electron injecting layer or inorganic insulative electron injecting and transporting layer becomes stable. The organic EL device of the invention produces a luminance at least equal to that of prior art devices having an organic hole injecting layer or organic electron injecting layer. Owing to high heat resistance and weather resistance, the organic EL device of the invention has a longer service life than the prior art devices and develops minimal leaks and dark spots. Since an inexpensive, readily available, easy-to-prepare inorganic material are used rather than a relatively expensive organic material, the cost of manufacture can be reduced.

The high-resistance inorganic electron injecting layer is capable of blocking holes and has conduction paths for carrying electrons. The provision of a high-resistance inorganic electron injecting layer capable of blocking holes and having conduction paths for carrying electrons between the organic layer and the electron injecting electrode (or cathode) enables efficient injection of electrons into the light emitting layer, leading to an improved emission efficiency and a lower drive voltage.

In the preferred high-resistance inorganic electron injecting layer, a second component is contained in an amount of 0.2 to 40 mol% based on the entire components to create conduction paths. This enables effective injection of electrons from the electron injecting electrode into the organic layer on the light emitting layer side. Additionally, the migration of holes from the organic layer to the electron injecting electrode is restrained, ensuring effective recombination of holes and electrons in the light emitting layer. The organic EL device of the invention has both the advantages of inorganic material and the advantages of organic material. The organic EL device of the invention produces a luminance at least equal to that of prior art devices having an organic electron injecting layer. Owing to high heat resistance and weather resistance, the organic EL device of the invention has a longer service life than the prior art devices and develops minimal leaks and dark spots. Since not only a relatively expensive organic material, but also an inexpensive, readily available, easy-to-prepare inorganic material are used, the cost of manufacture can be reduced.

The high-resistance inorganic electron injecting layer should preferably have a resistivity of 1 to 1x10¹¹ Ω-cm and especially 1x10³ to 1x10⁸ Ω-cm. By controlling the resistivity of the inorganic electron injecting layer within this range, the efficiency of electron injection can be drastically increased while maintaining high hole blockage. The resistivity of the inorganic electron injecting layer may be determined from a sheet resistance and a film thickness.

Preferably, the high-resistance inorganic electron injecting layer contains as a first component an oxide of any one of;
at least one alkali metal element, preferably selected from among Li, Na, K, Rb, Cs and Fr,
at least one alkaline earth metal element, preferably selected from among Mg, Ca and Sr, and
at least one lanthanoid element, preferably selected from La and Ce,
the oxide having a work function of up to 4 eV, and preferably 1 to 4 eV. Of these, lithium oxide, magnesium oxide, calcium oxide and cerium oxide are preferred. When a mixture of any two or more of these oxides is used, the mixing ratio is not critical. Preferably the mixture contains at least 50 mol% calculated as Li₂O of lithium oxide.

In the high-resistance inorganic electron injecting layer, at least one element selected from among Zn, Sn, V, Ru, Sm and In is contained as a second component. The content of the second component is preferably 0.2 to 40 mol%, and more preferably 1 to 20 mol%. Outside the range, a less content may lead to a lower electron injecting function whereas a larger content may lead to a lower hole blocking function. When two or more elements are combined, the total content should preferably fall within the above range. The second component may be present in either an elemental form or an oxide form.

It is believed that the incorporation of the second component having a conductivity or low resistance in the first component having a high resistance means that the conductive material is distributed in the insulating material in island form, creating hopping paths for electron injection.

The oxide as the first component usually has a stoichiometric composition, but may have a non-stoichiometric composition deviating somewhat therefrom. The second component is generally present as an oxide, to which the same as above applies.

In addition, the high-resistance inorganic electron injecting layer may contain less than about 5 at% in total of impurities such as H, or Ne, Ar, Kr and Xe used as the sputtering gas.

As long as the overall inorganic electron injecting layer has the above-described composition on the average, the composition of the inorganic electron injecting layer need not be uniform. A layer structure having a graded concentration in a thickness direction is acceptable.

The high-resistance inorganic electron injecting layer is normally amorphous.

The high-resistance inorganic electron injecting layer preferably has a thickness of about 0.3 nm to about 30 nm, more preferably about 1 nm to about 20 nm. Electron injection would become insufficient when the thickness of the electron injecting layer is outside the range.

Instead of the high-resistance inorganic electron injecting layer, there may be provided an inorganic insulative electron injecting and transporting layer to be described below.

The inorganic insulative electron injecting and transporting layer has the functions of facilitating injection of electrons from the negative electrode, transporting electrons in a stable manner, and blocking holes. This layer is effective for increasing the number of holes and electrons injected into the lighL emitting layer and confining holes and electrons therein for optimizing the recombination region to improve luminous efficiency.

Specifically, when the inorganic insulative electron injecting and transporting layer is composed of a main component to be described below, a need to form a special electrode having an electron injecting function is eliminated, and a metal electrode having a relatively high stability and a good conductivity may be used. Other advantages include an improved electron injection efficiency, an improved emission efficiency and an extended device life.

The inorganic insulative electron injecting and transporting layer contains at least one oxide selected from the group consisting of lithium oxide (Li₂O), rubidium oxide (Rb₂O), potassium oxide (K₂O), sodium oxide (Na₂O), cesium oxide (Cs₂O), strontium oxide (SrO), magnesium oxide (MgO), and calcium oxide (CaO) as the main component. These oxides may be used alone or in admixture of two or more. The mixture of two or more oxides may have an arbitrary mix ratio. Of these oxides, strontium oxide is most preferred; magnesium oxide, calcium oxide and lithium oxide are more preferable in the described order; and in the next place, rubidium oxide, and further in the next place, potassium oxide and sodium oxide are preferable. When these oxides are used in admixture, the mixture should preferably contain at least 40 mol%, especially at least 50 mol% of strontium oxide or at least 40 mol%, especially at least 50 mol% of lithium oxide and rubidium oxide combined.

The inorganic insulative electron injecting and transporting layer preferably contains silicon oxide (SiO₂) and/or germanium oxide (GeO₂) as the stabilizer. Either one or both of silicon oxide and germanium oxide may be used. The mixture of silicon oxide and germanium oxide may have an arbitrary mix ratio.

These oxides are generally present in stoichiometric composition, but may deviate more or less therefrom and take non-stoichiometric compositions.

Also preferably, the inorganic insulative electron injecting and transporting layer contains the respective components in the following amounts:
main component: 80 to 99 mol%, more preferably 90 to 95 mol%,
stabilizer: 1 to 20 mol%, more preferably 5 to 10 mol%,
based on the entire components, provided that the respective components are calculated as SrO, MgO, CaO, Li₂O, Rb₂O, K₂O, Na₂O, Cs₂O, SiO₂, and GeO₂.

The inorganic insulative electron injecting and transporting layer preferably has a thickness of 0.1 to 2 nm, more preferably 0.3 to 0.8 nm.

Referring to FIGS. 1 and 2, there are illustrated in schematic views the configuration of organic EL devices according to different embodiments of the invention. The device of FIG. 1 has the successively stacked configuration of substrate 1/hole injecting electrode 2/high-resistance inorganic hole injecting layer 4/light emitting layer 5/inorganic or organic electron injecting and transporting layer 6/negative electrode (electron injecting electrode) 3. The device of FIG. 2 has the inversely stacked configuration of substrate 1/negative electrode (electron injecting electrode) 3/inorganic or organic electron injecting and transporting layer 6/light emitting layer 5/high-resistance inorganic hole injecting layer 4/hole injecting electrode 2. The inversely stacked configuration helps light emerge from the side of the assembly opposite to the substrate. In the inversely stacked configuration, however, when the high-resistance inorganic hole injecting layer is deposited, the organic layer and other layer (if any) can be subjected to ashing and hence, damaged. It is thus recommended that the hole injecting layer is initially thinly deposited in the absence of oxygen and then thickly in the presence of oxygen. The thickness reached in the absence of oxygen is preferably about 1/5 to about 1/2 of the final thickness. In FIGS. 1 and 2, a drive power supply E is connected between the hole injecting electrode 2 and the electron injecting electrode 3. It is understood that the light emitting layer 5 is a light emitting layer of broader definition including an electron transporting layer, a light emitting layer of narrower definition, a hole transporting layer, and so on.

The device of the invention may have a multi-stage configuration of electrode layer/inorganic layer and light emitting layer/electrode layer/inorganic layer and light emitting layer/electrode layer/inorganic layer and light emitting layer/electrode layer, or further repeated layers. Such a multi-stage configuration is effective for adjusting or multiplying the color of emitted light.

For the hole injecting electrode, materials capable of effectively injecting holes into the hole injecting layer are preferred. Useful are compositions based on tin-doped indium oxide (ITO), zinc-doped indium oxide (IZO), indium oxide (In₂O₃), tin oxide (SnO₂) or zinc oxide (ZnO). These oxides may deviate more or less from their stoichiometric compositions. For ITO, an appropriate proportion of SnO₂ mixed with In₂O₃ is about 1 to 20%, more preferably about 5 to 12% by weight. For IZO, an appropriate proportion of ZnO mixed with In₂O₃ is about 12 to 32% by weight. The hole injecting electrode may further contain silicon oxide (SiO₂). The content of silicon oxide (SiO₂) is preferably about 0.5 to 10% as expressed in mol percent of SiO₂ based on ITO.

The electrode on the light output side should preferably have a light transmittance of at least 50%, more preferably at least 60%, further preferably at least 80%, most preferably at least 90% in the light emission band, typically from 400 to 700 nm, and especially at each light emission. With a lower transmittance, the light emitted by the light emitting layer is attenuated through the electrode, failing to provide a luminance necessary as a light emitting device. It is noted that the light transmittance of the electrode is sometimes set low for the purpose of increasing the contrast ratio for improving visual perception.

Preferably the electrode has a thickness of 50 to 500 nm, especially 50 to 300 nm. Although the upper limit of the electrode thickness is not critical, a too thick electrode would cause a drop of transmittance and separation. Too thin an electrode is insufficient for its effect and low in film strength during fabrication.

In the embodiment wherein the electron injecting electrode or negative electrode is combined with the high-resistance inorganic electron injecting layer and inorganic insulative electron injecting and transporting layer, the material of which the electron injecting electrode or negative electrode is made is not critical because the electrode need not have a low work function and electron injection capability. Ordinary metals may be used for the negative electrode. Inter alia, one or more metal elements selected from Al, Ag, In, Ti, Cu, Au, Mo, W, Pt, Pd and Ni, and especially Al and Ag are preferred because of their conductivity and ease of handling.

The negative electrode thin film may have at least a sufficient thickness to supply electrons to the high-resistance inorganic electron injecting and transporting layer, for example, a thickness of at least 50 nm, preferably at least 100 nm. Although the upper limit is not critical, the electrode thickness is typically about 50 to about 500 nm.

If desired, the electron injecting electrode is formed from metal elements such as K, Li, Na, Mg, La, Ce, Ca, Sr, Ba, Al, Ag, In, Sn, Zn, and Zr, and binary or ternary alloys made of two or three such metal elements for stability improvement. Exemplary alloys are Ag-Mg (Ag: 0.1 to 50 at%), Al-Li (Li: 0.01 to 14 at%), In-Mg (Mg: 50 to 80 at%), and Al-Ca (Ca: 0.01 to 20 at%).

The electron injecting electrode thin film may have at least a sufficient thickness to effect electron injection, for example, a thickness of at least 0.1 nm, preferably at least 0.5 nm, more preferably at least 1 nm. Although the upper limit is not critical, the electrode thickness is typically about 1 to about 500 nm.

On the electron injecting electrode, an auxiliary or protective electrode may be provided, if desired. The auxiliary electrode may have at least a sufficient thickness to ensure efficient electron injection and prevent the ingress of moisture, oxygen and organic solvents, for example, a thickness of at least 50 nm, preferably at least 100 nm, more preferably 100 to 500 nm. A too thin auxiliary electrode layer would exert its effect little, lose a step coverage capability, and provide insufficient connection to a terminal electrode. If too thick, greater stresses are generated in the auxiliary electrode layer, accelerating the growth rate of dark spots.

For the auxiliary electrode, an appropriate material may be chosen in consideration of the material of the electron injecting electrode to be combined therewith. For example, low resistivity metals such as aluminum may be used when electron injection efficiency is of importance. Metal compounds such as TiN may be used when sealing is of importance.

The thickness of the electron injecting electrode and the auxiliary electrode combined is usually about 50 to about 500 nm though it is not critical.

The light emitting layer is a thin film of an organic compound participating in light emission or a multilayer film of two or more organic compounds participating in light emission.

The light emitting layer has the functions of injecting holes and electrons, transporting them, and recombining holes and electrons to create excitons. It is preferred that relatively electronically neutral compounds be used in the light emitting layer so that electron and holes may be readily injected and transported in a well-balanced manner.

In addition to the light emitting layer of the narrow definition, the light emitting layer may optionally include such layers as an electron injecting and transporting layer. The organic electron injecting and transporting layer has the functions of facilitating injection of electrons from the electron injecting electrode, transporting electrons stably, and blocking holes. This layer is effective for increasing the number of holes and electrons injected into the light emitting layer and confining holes and electrons therein for optimizing the recombination region to improve light emission efficiency.

The thicknesses of the light emitting layer and the electron injecting and transporting layer are not critical and vary with a particular formation technique although their thickness is usually preferred to range from about 5 nm to about 500 nm, especially about 10 nm to about 300 nm.

The thickness of the electron injecting and transporting layer is equal to or ranges from about 1/10 times to about 10 times the thickness of the light emitting layer although it depends on the design of a recombination/light emitting region. When the electron injecting and transporting layer is divided into an injecting layer and a transporting layer, preferably the injecting layer is at least 1 nm thick and the transporting layer is at least 1 nm thick. The upper limit of thickness is usually about 500 nm for the injecting layer and about 500 nm for the transporting layer. The same film thickness applies when two injecting/transporting layers are provided.

The light emitting layer of the organic EL device of the invention contains a fluorescent material that is a compound having a light emitting capability. The fluorescent material may be at least one member selected from compounds as disclosed, for example, in JP-A 63-264692, such as quinacridone, rubrene, and styryl dyes. Also, quinoline derivatives such as metal complex dyes having 8-quinolinol or a derivative thereof as the ligand such as tris(8-quinolinolato)aluminum are included as well as tetraphenylbutadiene, anthracene, perylene, coronene, and 12-phthaloperinone derivatives. Further useful are the phenylanthracene derivatives described in JP-A 8-12600 and the tetraarylethene derivatives described in JP-A 8-12969.

It is preferred to use such a compound in combination with a host material capable of light emission by itself, that is, to use the compound as a dopant. In this embodiment, the content of the compound in the light emitting layer is preferably 0.01 to 10% by volume, especially 0.1 to 5% by volume. An appropriate amount of the rubrene compound is 0.01 to 20% by volume. By using the compound in combination with the host material, the light emission wavelength of the host material can be altered, allowing light emission to be shifted to a longer wavelength and improving the luminous efficacy and stability of the device.

As the host material, quinolinolato complexes are preferable, with aluminum complexes having 8-quinolinol or a derivative thereof as the ligand being more preferable. These aluminum complexes are disclosed in JP-A 63-264692, 3-255190, 5-70733, 5-258859 and 6-215874.

Illustrative examples include tris(8-quinolinolato)aluminum, bis(8-quinolinolato)magnesium, bis(benzo{*f*}-8-quinolinolato)zinc, bis(2-methyl-8-quinolinolato)aluminum oxide, tris(8-quinolinolato)indium, tris(5-methyl-8-quinolinolato)aluminum, 8-quinolinolatolithium, tris(5-chloro-8-quinolinolato)gallium, bis(5-chloro-8-quinolinolato)calcium, 5,7-dichloro-8-quinolinolato-aluminum, tris(5,7-dibromo-8-hydroxyquinolinolato)-aluminum, and poly[zinc(II)-bis(8-hydroxy-5-quinolinyl)methane].

Also useful are aluminum complexes having another ligand in addition to 8-quinolinol or a derivative thereof. Examples include bis(2-methyl-8-quinolinolato)(phenolato)aluminum(III), bis(2-methyl-8-quinolinolato)(ortho-cresolato)aluminum(III), bis(2-methyl-8-quinolinolato)(meta-cresolato)aluminum(III), bis(2-methyl-8-quinolinolato)(para-cresolato)aluminum(III), bis(2-methyl-8-quinolinolato)(ortho-phenylphenolato)aluminum(III), bis(2-methyl-8-quinolinolato) (meta-phenylphenolato)aluminum(III), bis(2-methyl-8-quinolinolato)(para-phenylphenolato)aluminum (III), bis(2-methyl-8-quinolinolato)(2,3-dimethylphenolato)aluminum(III), bis(2-methyl-8-quinolinolato)(2,6-dimethylphenolato)aluminum(III), bis(2-methyl-8-quinolinolato)-(3,4-dimethylphenolato)aluminum(III), bis(2-methyl-8-quinolinolato)(3,5-dimethylphenolato)aluminum(III), bis(2-methyl-8-quinolinolato)(3,5-di-tert-butylphenolato)aluminum(III), bis(2-methyl-8-quinolinolato)(2,6-diphenylphenolato)aluminum(III), bis(2-methyl-8-quinolinolato)(2,4,6-triphenylphenolato)aluminum(III), bis(2-methyl-8-quinolinolato) (2,3,6-trimethylphenolato)aluminum(III), bis(2-methyl-8-quinolinolato)(2,3,5,6-tetramethylphenolato)aluminum(III), bis(2-methyl-8-quinolinolato)(1-naphtholato)aluminum(III), bis(2-methyl-8-quinolinolato)(2-naphtholato)aluminum(III), bis(2,4-dimethyl-8-quinolinolato)(ortho-phenylphenolato)aluminum(III), bis(2,4-dimethyl-8-quinolinolato)(para-phenylphenolato)aluminum(III), bis(2,4-dimethyl-8-quinolinolato)(metaphenylphenolato)aluminum(III), bis(2,4-dimethyl-8-quinolinolato) (3,5-dimethylphenolato)aluminum(III), bis(2,4-dimethyl-8-quinolinolato)(3,5-di-tert-butylphenolato)aluminum(III), bis(2-methyl-4-ethyl-8-quinolinolato)(para-cresolato)aluminum(III), bis(2-methyl-4-methoxy-8-quinolinolato)(para-phenylphenolato)aluminum(III), bis(2-methyl-5-cyano-8-quinolinolato)(ortho-cresolato)aluminum(III), and bis(2-methyl-6-trifluoromethyl-8-quinolinolato)(2-naphtholato)aluminum(III).

Also acceptable are bis(2-methyl-8-quinolinolato)aluminum(III)-u-oxo-bis(2-methyl-8-quinolinolato)aluminum (III), bis(2,4-dimethyl-8-quinolinolato)aluminum(III)-µ-oxo-bis(2,4-dimethyl-8-quinolinolato)aluminum(III), bis(4-ethyl-2-methyl-8-quinolinolato)aluminum(III)-u-oxo-bis(4-ethyl-2-methyl-8-quinolinolato)aluminum(III), bis(2-methyl-4-methoxyquinolinolato)aluminum(III)-u-oxo-bis(2-methyl-4-methoxyquinolinolato)aluminum(III), bis(5-cyano-2-methyl-8-quinolinolato)aluminum(III)-µ-oxo-bis(5-cyano-2-methyl-8-quinolinolato)aluminum(III), and bis(2-methyl-5-trifluoromethyl-8-quinolinolato)aluminum(III)-µ-oxo-bis(2-methyl-5-trifluoromethyl-8-quinolinolato)aluminum(III).

Other useful host materials are the phenylanthracene derivatives described in JP-A 8-12600 and the tetraarylethene derivatives described in JP-A 8-12969.

The light emitting layer may also serve as the electron injecting and transporting layer. In this case, tris(8-quinolinolato)aluminum etc. are preferably used. These fluorescent materials may be evaporated.

Also, if necessary, the light emitting layer may also be a layer of a mixture of at least one hole injecting and transporting compound and at least one electron injecting and transporting compound, in which a dopant is preferably contained. In such a mix layer, the content of the dopant is preferably 0.01 to 20% by volume, especially 0.1 to 15% by volume.

In the mix layer, carrier hopping conduction paths are created, allowing carriers to move through a polarly predominant material while injection of carriers of opposite polarity is rather inhibited, and the organic compound becomes less susceptible to damage, resulting in the advantage of an extended device life. By incorporating the aforementioned dopant in such a mix layer, the light emission wavelength the mix layer itself possesses can be altered, allowing light emission to be shifted to a longer wavelength and improving the luminous intensity and stability of the device.

The hole injecting and transporting compound and electron injecting and transporting compound used in the mix layer may be selected from the hole injecting and transporting compounds and electron injecting and transporting compounds to be described later, respectively. Inter alia, the hole injecting and transporting compound is preferably selected from amine derivatives having strong fluorescence, for example, triphenyldiamine derivatives which are hole transporting materials, styrylamine derivatives and amine derivatives having an aromatic fused ring.

The electron injecting and transporting compound is preferably selected from quinoline derivatives and metal complexes having 8-quinolinol or a derivative thereof as a ligand, especially tris(8-quinolinolato)aluminum (Alq3). The aforementioned phenylanthracene derivatives and tetraarylethene derivatives are also preferable.

As the hole injecting and transporting compound, amine derivatives having intense fluorescence are useful, for example, the triphenyldiamine derivatives, styrylamine derivatives, and amine derivatives having an aromatic fused ring, exemplified above as the hole injecting and transporting material.

The mix ratio is preferably determined in accordance with the carrier density and carrier mobility. It is usually preferred that the weight ratio of the hole injecting and transporting compound to the electron injecting and transporting compound range from about 1/99 to about 99/1, more preferably from about 10/90 to about 90/10, especially from about 20/80 to about 80/20.

Also preferably, the thickness of the mix layer ranges from the thickness of a mono-molecular layer to less than the thickness of the organic compound layer, specifically from 1 to 85 nm, more preferably 5 to 60 nm, especially 5 to 50 nm.

Preferably the mix layer is formed by a co-deposition process of evaporating the compounds from distinct sources. If both the compounds have approximately equal or very close vapor pressures or evaporation temperatures, they may be pre-mixed in a common evaporation boat, from which they are evaporated together. The mix layer is preferably a uniform mixture of both the compounds although the compounds can be present in island form. The light emitting layer is generally formed to a predetermined thickness by evaporating an organic fluorescent material or coating a dispersion thereof in a resin binder.

In the electron injecting and transporting layer which is optionally provided, there may be used quinoline derivatives including organic metal complexes having 8-quinolinol or a derivative thereof as a ligand such as tris(8-quinolinolato)aluminum, oxadiazole derivatives, perylene derivatives, pyridine derivatives, pyrimidine derivatives, quinoxaline derivatives, diphenylquinone derivatives, and nitro-substituted fluorene derivatives. The electron injecting and transporting layer can also serve as the light emitting layer. In this case, use of tris(8-quinolinolato)aluminum etc. is preferred. Like the light emitting layer, the electron injecting and transporting layer may be formed by evaporation or the like.

Where the electron injecting and transporting layer is formed separately as an electron injecting layer and an electron transporting layer, two or more compounds are selected in a proper combination from the compounds commonly used in electron injecting and transporting layers. In this regard, it is preferred to stack layers in such an order that a layer of a compound having a greater electron affinity may be disposed adjacent the electron injecting electrode. The order of stacking also applies where a plurality of electron injecting and transporting layers are provided.

In forming the organic hole injecting and transporting layer, the light emitting layer, and the electron injecting and transporting layer, vacuum evaporation is preferably used because homogeneous thin films are available. By utilizing vacuum evaporation, there is obtained a homogeneous thin film which is amorphous or has a crystal grain size of less than 0.2 µm. If the grain size is more than 0.2 µm, uneven light emission would take place and the drive voltage of the device must be increased with a substantial drop of hole injection efficiency.

The conditions for vacuum evaporation are not critical although a vacuum of 10⁻⁴ Pa or lower and a deposition rate of about 0.01 to 1 nm/sec. are preferred. It is preferred to successively form layers in vacuum because the successive formation in vacuum can avoid adsorption of impurities on the interface between the layers, thus ensuring better performance. Also, the drive voltage of a device can be reduced and the development and growth of dark spots be restrained.

In the embodiment wherein the respective layers are formed by vacuum evaporation, where it is desired for a single layer to contain two or more compounds, boats having the compounds received therein are individually temperature controlled to achieve co-deposition.

Further preferably, a shield plate may be provided on the device in order to prevent the organic layers and electrodes from oxidation. In order to prevent the ingress of moisture, the shield plate is attached to the substrate through an adhesive resin layer for sealing. The sealing gas is preferably an inert gas such as argon, helium, and nitrogen. The inert gas should preferably have a moisture content of less than 100 ppm, more preferably less than 10 ppm, especially less than 1 ppm. The lower limit of the moisture content is usually about 0.1 ppm though not critical.

The shield plate is selected from plates of transparent or translucent materials such as glass, quartz and resins, with glass being especially preferred. Alkali glass is preferred because of economy although other glass compositions such as soda lime glass, lead alkali glass, borosilicate glass, aluminosilicate glass, and silica glass are also useful. Of these, plates of soda glass without surface treatment are inexpensive and useful. Metal plates and plastic plates may also be used as the shield plate.

Using a spacer for height adjustment, the shield plate may be held at a desired height over the layer structure. The spacer may be formed from resin beads, silica beads, glass beads, and glass fibers, with the glass beads being especially preferred. Usually the spacer is formed from particles having a narrow particle size distribution while the shape of particles is not critical. Particles of any shape which does not obstruct the spacer function may be used. Preferred particles have an equivalent circle diameter of about 1 to 20 µm, more preferably about 1 to 10 µm, most preferably about 2 to 8 µm. Particles of such diameter should preferably have a length of less than about 100 µm. The lower limit of length is not critical although it is usually equal to or more than the diameter.

When a shield plate having a recess is used, the spacer may be used or not. When used, the spacer should preferably have a diameter in the above-described range, especially 2 to 8 µm,

The spacer may be premixed in a sealing adhesive or mixed with a sealing adhesion at the time of bonding. The content of the spacer in the sealing adhesive is preferably 0.01 to 30% by weight, more preferably 0.1 to 5% by weight.

Any of adhesives which can maintain stable bond strength and gas tightness may be used although UV curable epoxy resin adhesives of cation curing type are preferred.

In the organic EL structure of the invention, the substrate may be selected from amorphous substrates of glass and quartz and crystalline substrates of Si, GaAs, ZnSe, ZnS, GaP, and InP, for example. If desired, buffer layers of crystalline materials, amorphous materials or metals may be formed on such crystalline substrates. Metal substrates including Mo, Al, Pt, Ir, Au and Pd are also useful. Of these, glass substrates are preferred. Since the substrate is often situated on the light output side, the substrate should preferably have a light transmittance as described above for the electrode.

A plurality of inventive devices may be arrayed on a plane. A color display is obtained when the respective devices of a planar array differ in emission color.

The substrate may be provided with a color filter film, a fluorescent material-containing color conversion film or a dielectric reflecting film for controlling the color of light emission.

The color filter film used herein may be a color filter as used in liquid crystal displays and the like. The properties of a color filter may be adjusted in accordance with the light emission of the organic EL device so as to optimize the extraction efficiency and color purity. It is also preferred to use a color filter capable of cutting external light of short wavelength which is otherwise absorbed by the EL device materials and fluorescence conversion layer, because the light resistance and display contrast of the device are improved. An optical thin film such as a multilayer dielectric film may be used instead of the color filter.

The fluorescence conversion filter film is to convert the color of light emission by absorbing electroluminescence and allowing the fluorescent material in the film to emit light. It is formed from three components: a binder, a fluorescent material, and a light absorbing material. The fluorescent material used may basically have a high fluorescent quantum yield and desirably exhibits strong absorption in the electroluminescent wavelength region. In practice, laser dyes are appropriate. Use may be made of rhodamine compounds, perylene compounds, cyanine compounds, phthalocyanine compounds (including sub-phthalocyanines), naphthalimide compounds, fused ring hydrocarbon compounds, fused heterocyclic compounds, styryl compounds, and coumarin compounds. The binder is selected from materials which do not cause extinction of fluorescence, preferably those materials which can be finely patterned by photolithography or printing technique. Also, where the filter film is formed on the substrate so as to be contiguous to the hole injecting electrode, those materials which are not damaged during deposition of the hole injecting electrode (such as ITO or IZO) are preferable. The light absorbing material is used when the light absorption of the fluorescent material is short, and may be omitted if unnecessary. The light absorbing material may also be selected from materials which do not cause extinction of fluorescence of the fluorescent material.

The organic EL device of the invention is generally of the dc or pulse drive type. The applied voltage is generally about 2 to 30 volts.

In addition to the display application, the organic EL device of the invention may find use as various optical devices such as optical pickups for use in reading and writing in storages, repeaters in transmission lines for optical communication, and photo couplers.

### EXAMPLE

Examples of the invention are given below by way of illustration and not by way of limitation.

### Example 1

A substrate of (7059) glass by Corning Glass Works was scrubbed using a neutral detergent.

By RF magnetron sputtering from a target of ITO oxide, a hole injecting electrode layer of ITO having a thickness of 200 nm was formed on the substrate at a temperature of 250°C.

After its ITO electrode-bearing surface was cleaned with UV/0₃, the substrate was secured by a holder in a sputtering chamber, which was evacuated to a vacuum of 1x10⁻⁴ Pa or lower.

Using a target of GeO₂ having a properly sized pellet of In₂O₃ (resistivity 1x10³ Ω-cm) rested thereon, a high-resistance inorganic hole injecting layer was deposited to a thickness of 20 nm. The sputtering gas used was a mixture of 30 sccm of Ar and 5 sccm of O₂. Sputtering conditions included room temperature (25°C), a deposition rate of 1 nm/min., an operating pressure of 0.2 to 2 Pa, and an input power of 500 W. The inorganic hole injecting layer as deposited had a composition of GeO_{1.9} containing 2 mol% of In₂O₃.

With the vacuum kept, N,N,N',N'-tetrakis(m-biphenyl)-1,1'-biphenyl-4,4'-diamine (TPD), tris(8-quinolinolato)aluminum (Alq3), and rubrene were evaporated at an overall deposition rate of 0.2 nm/sec. to a thickness of 100 nm, forming a light emitting layer. The layer consisted of a mixture of TPD and Alq3 in a volume ratio of 1:1 doped with 10 vol% of rubrene.

Subsequently, tris(8-quinolinolato)aluminum (Alq3) was evaporated at a deposition rate of 0.2 nm/sec to a thickness of 30 nm, forming an organic electron injecting and transporting layer.

With the vacuum kept, AlLi (Li: 7 at%) was evaporated to a thickness of 5 nm, and Al was successively evaporated to a thickness of 200 nm to form a negative electrode. A glass shield was sealed to the layer structure to complete an organic EL device.

The organic EL device thus constructed was driven in air at a constant current density of 10 mA/cm², finding an initial luminance of 1,450 cd/m² and a drive voltage of 7.8 V. When an accelerated test was carried out by driving the device at a current density of 100 mA/cm², this organic EL device showed a luminance half-life of more than 200 hours.

The sheet resistance of the high-resistance inorganic hole injecting layer was measured by the four-terminal method. The layer having a thickness of 100 nm showed a sheet resistance of 10 kΩ/cm², which corresponds to a resistivity of 1x10⁹ Ω-cm.

### Example 2

An organic EL device was fabricated as in Example 1 except that in the step of forming the electron injecting and transporting layer, with the vacuum kept, the substrate was transferred to a sputtering chamber. Using a target in which strontium oxide (SrO), lithium oxide (Li₂O) and silicon oxide (SiO₂) were mixed as raw materials so as to give the composition:
SrO: 80 mol%,
Li₂O: 10 mol%, and
SiO₂: 10 mol%
based on the entire components, an inorganic electron injecting and transporting layer was deposited to a thickness of 0.8 nm. Sputtering conditions included a substrate temperature of 25°C, sputtering gas Ar, a deposition rate of 1 nm/min., an operating pressure of 0.5 Pa, and an input power of 5 W/cm². Specifically, the inorganic electron injecting and transporting layer was initially deposited to a thickness of 0.4 nm while feeding 100% Ar as the sputtering gas at 100 sccm, and then to a thickness of 0.4 nm while feeding a 1/1 mixture of Ar and O₂ at 100 sccm.

With the vacuum kept, Al was evaporated to a thickness of 200 nm to form a negative electrode. A glass shield was sealed to the layer structure to complete an organic EL device.

When the organic EL device thus constructed was tested as in Example 1, this device was improved in luminance half-life over Example 1, with the remaining properties being equivalent.

### Example 3

An organic EL device was fabricated as in Example 1 except that in the step of forming the electron injecting and transporting layer, the substrate was transferred to a sputtering chamber. Using a target of Li₂O having 4 mol% of V mixed therewith, a high-resistance inorganic electron injecting layer was deposited to a thickness of 10 nm. Sputtering conditions included room temperature (25°C), sputtering gas of 30 sccm Ar and 5 sccm O₂, a deposition rate of 1 nm/min., an operating pressure of 0.2 to 2 Pa, and an input power of 500 W. The inorganic electron injection layer as deposited had substantially the same composition as the target.

With the vacuum kept, Al was evaporated to a thickness of 200 nm to form a negative electrode. A glass shield was sealed to the layer structure to complete an organic EL device.

When the organic EL device thus constructed was tested as in Example 1, this device was improved in initial luminance at a constant current density and luminance half-life over Example 2.

### Example 4

Organic EL devices were fabricated as in Examples 1 to 3 except that in the step of depositing the high-resistance inorganic hole injecting and transporting layer, the flow rate of O₂ in the sputtering gas and the target were changed for a desired film composition so that the main component of the layer had the composition: SiO_{1.9}, SiO_{1.7}, SiO_{1.95} GeO_{1.96} or Si_{0.5}Ge_{0.5}O_{1.92}. These devices were tested for luminance, finding approximately equivalent results.

### Example 5

In Examples 1 to 3, the oxide of the high-resistance inorganic hole injecting layer was changed from In₂O₃, (resistivity 1x10³ Ω-cm) to ZnO (resistivity 1x10⁴ Ω-cm), RuO₂ (resistivity 1x10⁻⁴ Ω-cm) or V₂O₃ (resistivity 0.1 Ω-cm), finding equivalent results.

### Example 6

In Example 2, the main component of the inorganic insulative electron injecting and transporting layer was changed from SrO to MgO, CaO or a mixture of these oxides, and from Li₂O to K₂O, Rb₂O, K₂O, Na₂O, Cs₂O or a mixture of these oxides, and the stabilizer was changed from SiO₂ to GeO₂ or an oxide mixture of SiO₂ and GeO₂, finding approximately equivalent results. Similar results were obtained when the material of the negative electrode was changed from Al to Ag, In, Ti, Cu, Au, Mo, W, Pt, Pd, Ni or an alloy thereof.

### Example 7

In Example 3, the composition of the high-resistance inorganic electron injecting layer was changed from Li₂O to an oxide of at least one element selected from among alkali metal elements: Na, K, Rb, Cs and Fr, alkaline earth elements: Be, Mg, Ca, Sr, Ba and Ra, and lanthanoid elements: La, Ce, Pr, Nd, Pm, Sm, Eu, Gd, Tb, Dy, Ho, Er, Tm, Yb, and Lu, obtaining similar results.

Similar results were obtained when In was changed to at least one element selected from among Ru, Zn, Sm and In.

### Comparative Example 1

In Example 1, after the substrate having an ITO electrode layer formed thereon was cleaned at its surface with UV/O₃, the substrate was secured by a holder in a vacuum deposition chamber, which was evacuated to a vacuum of 1x10⁻⁴ Pa or lower.

With the vacuum kept, N,N,N',N'-tetrakis(m-biphenyl)-1,1'-biphenyl-4,4'-diamine (TPD) was evaporated at a deposition rate of 0.2 nm/sec. to a thickness of 200 nm, forming a hole injecting and transporting layer.

Otherwise as in Example 1, an organic EL device was fabricated. The organic EL device thus constructed was driven in air at a constant current density of 10 mA/cm², finding an initial luminance of 800 cd/m² and a drive voltage of 7.5 V.

There has been described an organic EL device having a high-resistance inorganic hole injecting layer of silicon and/or germanium oxide containing a conductive oxide between a hole injecting electrode and an organic layer, which features efficient hole injection, efficient recombination of holes and electrons in the light emitting layer, a high light emission efficiency, a low drive voltage and a low cost.

Japanese Patent Application No. 11-096212 is incorporated herein by reference.

The invention has been described in detail with particular reference to preferred embodiments thereof, but it will be understood that variations and modifications can be effected within the spirit and scope of the invention.

## Claims

1. An organic electroluminescent device comprising a hole injecting electrode, a negative electrode, an organic layer or at least two organic layers of at least two distinct organic materials between the electrodes, at least one organic layer having a light emitting function, and a high-resistance inorganic hole injecting layer between said hole injecting electrode and said organic layer for blocking electrons and carrying holes,
said high-resistance inorganic hole injecting layer containing silicon oxide and/or germanium oxide as a main component, the main component being represented by the formula: (Si₁₋ₓGeₓ)O_{y} wherein x is from 0 to 1 and y is from 1.7 to 2.2, and a conductive oxide having a resistivity of up to 1x10¹⁰ Ω-cm.

2. The organic electroluminescent device of claim 1 wherein said conductive oxide is at least one of the oxides of In, Zn, Ru, and V.

3. The organic electroluminescent device of claim 1 wherein said high-resistance inorganic hole injecting layer has a resistivity of 1 to 1x10¹¹ Ω-cm.

4. The organic electroluminescent device of claim 1 wherein said high-resistance inorganic hole injecting layer contains 0.5 to 30 mol% of the conductive oxide.

5. The organic electroluminescent device of claim 1 wherein said high-resistance inorganic hole injecting layer has a thickness of 0.5 to 20 nm.

6. The organic electroluminescent device of claim 1 further comprising a high-resistance inorganic electron injecting layer between said organic layer and said negative electrode,
said high-resistance inorganic electron injecting layer containing as a first component at least one of the oxides of alkali metal elements, alkaline earth metal elements and lanthanoid elements having a work function of up to 4 eV, and as a second component at least one metal having a work function of 3 to 5 eV, said inorganic electron injecting layer being capable of blocking holes and having conduction paths for carrying electrons.

7. The organic electroluminescent device of claim 6 wherein said second component is at least one metal selected from the group consisting of Zn, Sn, V, Ru, Sm and In.

8. The organic electroluminescent device of claim 6 wherein said alkali metal element is at least one selected from the group consisting of Li, Na, K, Rb, Cs and Fr, said alkaline earth element is at least one selected from the group consisting of Mg, Ca and Sr, and said lanthanoid element is at least one selected from among La and Ce.

9. The organic electroluminescent device of claim 6 wherein said high-resistance inorganic electron injecting layer contains 0.2 to 40 mol% of the second component based on Lhe entire components.

10. The organic electroluminescent device of claim 6 wherein said high-resistance inorganic electron injecting layer has a thickness of 0.3 to 30 nm.

11. The organic electroluminescent device of claim 1 further comprising an inorganic insulative electron injecting and transporting layer between said organic layer and said negative electrode,
said inorganic insulative electron injecting and transporting layer containing as a main component at least one oxide selected from the group consisting of strontium oxide, magnesium oxide, calcium oxide, lithium oxide, rubidium oxide, potassium oxide, sodium oxide, and cesium oxide.

12. The organic electroluminescent device of claim 11 wherein said inorganic insulative electron injecting and transporting layer contains 80 to 99 mol% of the main component and 1 to 20 mol% of a stabilizer based on the entire components.

13. The organic electroluminescent device of claim 11 wherein said inorganic insulative electron injecting and transporting layer has a thickness of 0.1 to 2 nm.
